# EUROPEAN PATENT APPLICATION

(11) **EP 4 757 547 A1**
(43) Date of publication of application: **10.06.2026**
(21) Application number: 25164004.1
(22) Date of filing: 16.03.2025
(51) Int. Cl.: H10H 20/819, H10H 29/24

(54) **RING LIGHT SOURCE WITH ADJUSTABLE COLOR TEMPERATURE**

(30) Priority: 03.12.2024 CN 202422980697 U
(71) Applicant: Li, Wenjie, Guangzhou, Guangdong 510600 (CN)
(72) Inventor: Li, Wenjie, Guangzhou, Guangdong 510600 (CN)
(74) Representative: KIPA AB

(57) **Abstract**

A ring light source with adjustable color temperature are provided, relating to the technical field of light sources with adjustable color temperature. The ring light source includes a substrate and a light source group arranged on the substrate. The light source group includes a basic light source and a ring light source sleeved outside the basic light source; the basic light source is arranged with a basic P electrode and a basic N electrode, and the basic P electrode and the basic N electrode are electrically connected; the ring light source is arranged with a ring P electrode and a ring N electrode, and the ring P electrode and the ring N electrode are electrically connected; a color temperature of the basic light source is different from a color temperature of the ring light source; the basic light source and the ring light source are both flip-chip LED structures.

## Description

### FIELD

The present disclosure relates to the technical field of light sources with adjustable color temperature, in particular to a ring light source with adjustable color temperature.

### BACKGROUND

The color temperature of traditional LED light sources is a single design, which is related to a luminous principle of the light source. The light source itself can only emit a single color temperature from 2700 K to 6400 K according to the luminous principle of the light source during design, but the light source cannot be continuously adjusted from the low end (3000 K) to the high end (6000 K). At present, two kinds of single light sources with different high and low color temperatures are often used to integrate, so as to realize a transformation of various color temperatures. However, there is a gap between the single light sources, which leads to uneven light spots.

Therefore, the existing color temperature-adjustable light sources have problems of interval between different color temperature light sources, and problems of uneven light spots or uneven brightness.

### SUMMARY

In view of the shortcomings of the prior art, the purpose of the present disclosure is to provide a ring light source with adjustable color temperature, aiming to solve the problems of interval between different color temperature light sources and uneven light spots in the existing color temperature-adjustable light sources.

In order to achieve the purpose, the present disclosure adopts the following schemes. The present disclosure provides a ring light source with adjustable color temperature, including: a substrate; a light source group arranged on the substrate; where the light source group includes a basic light source and a ring light source sleeved outside the basic light source; the basic light source is arranged with a basic P electrode and a basic N electrode, and the basic P electrode and the basic N electrode are electrically connected; the ring light source is arranged with a ring P electrode and a ring N electrode, and the ring P electrode and the ring N electrode are electrically connected; a color temperature of the basic light source is different from a color temperature of the ring light source; the basic light source and the ring light source are both flip-chip LED structures.

The ring light source includes a first ring light source and a second ring light source, the first ring light source is sleeved outside the basic light source, and the second ring light source is sleeved outside the first ring light source; the ring P electrode includes a first P electrode and a second P electrode, and the ring N electrode includes a first N electrode and a second N electrode; the first P electrode and the first N electrode are both connected to the first ring light source, and the first P electrode and the first N electrode are electrically connected; the second P electrode and the second N electrode are both connected to the second ring light source, and the second P electrode and the second N electrode are electrically connected; the color temperature of the basic light source is different from a color temperature of the first ring light source, or the color temperature of the basic light source is different from a color temperature of the second ring light source.

The basic light source includes a basic fluorescent layer, the first ring light source includes a first fluorescent layer, and the second ring light source includes a second fluorescent layer; a thickness of the basic fluorescent layer is different from a thickness of the first fluorescent layer, or the thickness of the basic fluorescent layer is different from a thickness of the second fluorescent layer.

Fluorescent powder is arranged in the basic fluorescent layer, the first fluorescent layer, and the second fluorescent layer, and a thickness of the fluorescent powder in the basic fluorescent layer is different from a thickness in the first fluorescent layer, or the thickness of the fluorescent powder in the basic fluorescent layer is different from a thickness in the second fluorescent layer.

The basic light source further includes a basic luminescent layer, the basic P electrode and the basic N electrode are both arranged on the basic luminescent layer, and the basic fluorescent layer is arranged above the basic luminescent layer; the first ring light source further includes a first luminescent layer, where the first P electrode and the first N electrode are both arranged on the first luminescent layer, and the first fluorescent layer is arranged above the first luminescent layer; the second ring light source further includes a second luminescent layer, where the second P electrode and the second N electrode are both arranged on the second luminescent layer, and the second fluorescent layer is arranged above the second luminescent layer.

A thickness of the basic luminescent layer is different from a thickness of the first luminescent layer, or the thickness of the basic luminescent layer is different from a thickness of the second luminescent layer.

The basic light source further includes a basic P epitaxial layer and a basic N epitaxial layer, where the basic P electrode is arranged in the basic P epitaxial layer, the basic N electrode is arranged in the basic N epitaxial layer; the basic P epitaxial layer covers a lower surface of the basic luminescent layer, the basic N epitaxial layer covers an upper surface of the basic luminescent layer, and the basic fluorescent layer is arranged above the basic N epitaxial layer. The first ring light source further includes a first P epitaxial layer and a first N epitaxial layer, where the first P electrode is arranged in the first P epitaxial layer, the first N electrode is arranged in the first N epitaxial layer, the first P epitaxial layer covers a lower surface of the first luminescent layer, the first N epitaxial layer covers an upper surface of the first luminescent layer, and the first fluorescent layer is arranged above the first N epitaxial layer; the second ring light source further includes a second P epitaxial layer and a second N epitaxial layer, where the second P electrode is arranged in the second P epitaxial layer, the second N electrode is arranged in the second N epitaxial layer; the second P epitaxial layer covers a lower surface of the second luminescent layer, the second N epitaxial layer covers an upper surface of the second luminescent layer, and the second fluorescent layer is arranged above the second N epitaxial layer.

A basic gap is arranged between the basic luminescent layer and the basic N epitaxial layer, and the basic P electrode is electrically connected to the basic N electrode through the basic gap; a first gap is arranged between the first luminescent layer and the first N epitaxial layer, and the first P electrode is electrically connected to the first N electrode through the first gap; a second gap is arranged between the second luminescent layer and the second N epitaxial layer, and the second P electrode is electrically connected to the second N electrode through the second gap.

The ring light source further includes a third ring light source to an Xth ring light source; the first ring light source, the second ring light source and the third ring light source, up to the Xth ring light source, form a total of X ring light sources; the third ring light source is sleeved outside the second ring light source, and so on, with the Xth ring light source is sleeved outside an (X-1)th ring light source; a color temperature of the Xth ring light source is different from the color temperature of the basic light source, or the color temperature of the Xth ring light source is different from a color temperature of the (X-1)th ring light source.

The ring light source with adjustable color temperature further includes a lens, and the lens is arranged above the light source group.

Compared with the technicians in the art, the present disclosure provides a ring light source with adjustable color temperature, which includes a substrate and a light source group arranged on the substrate; the light source group includes a basic light source and a ring light source sleeved outside the basic light source; the basic light source and the ring light source are electrically connected through their own N electrodes and P electrodes, so that the battery cells of the basic light source and the ring light source can be adjusted to be different or the current power in the N electrodes and P electrodes of the two can be adjusted to make the color temperatures of the two different, thereby realizing various color temperature transformations. At the same time, both the basic light source and the ring light source are flip-chip LED structures, which can reduce the light shielding. The sleeved arrangement of the basic light source and the ring light source can reduce the interval between them, improve the effective output of light, and enhance the brightness and the uniformity of light spots.

### BRIEF DESCRIPTION OF THE DRAWINGS

Fig. 1 is a cross-sectional view of a ring light source with adjustable color temperature provided in one embodiment of the present disclosure.
Fig. 2 is a cross-sectional view of the ring light source with adjustable color temperature provided in another embodiment of the present disclosure.
Fig. 3 is a cross-sectional view of the ring light source with adjustable color temperature provided in another embodiment of the present disclosure.
Fig. 4 is a cutaway view of a light source group provided of the present disclosure.
Fig. 5 is a cutaway view of the light source group provided in another embodiment of the present disclosure.
Fig. 6 is a top view of the ring light source with adjustable color temperature provided in one embodiment of the present disclosure.
Fig. 7 is a top view of the ring light source with adjustable color temperature provided in another embodiment of the present disclosure.

Attached drawing marks:
1-light source group; 11-basic light source; 111-basic luminescent layer; 112-basic P epitaxial layer; 113-basic N epitaxial layer; 114-basic fluorescent layer; 115-basic gap; 12-first ring light source; 121-first luminescent layer; 122-first P epitaxial layer; 123-first N epitaxial layer; 124-first fluorescent layer; 125-first gap; 13-second ring light source; 131-second luminescent layer; 132- second P epitaxial layer; 133-second N epitaxial layer; 134-second fluorescent layer; 135-second gap; 14-third ring light source; 15-protective layer; 2-substrate; 3-protective shell; 4-lens.

### DETAILED DESCRIPTION OF EMBODIMENTS

Hereinafter, embodiments of the present disclosure are described in detail, examples of the embodiments are illustrated in the attached drawings, where the same or similar attached drawing marks indicate the same or similar elements or elements having the same or similar functions throughout. The embodiments described below by referring to the drawings are exemplary and are only used to explain the present disclosure, and cannot be understood as limitations of the present disclosure.

In the description of the present disclosure, it should be understood that the orientation or position relationship indicated by the terms "center", "longitudinal", "transverse", "upper", "lower", "front", "rear", "left", "right", "vertical", "horizontal", "top", "bottom", "inner", "outer", etc. is based on the orientation or position relationship shown in the attached drawings, which is only for the convenience of describing the present disclosure and simplifying the description, and is not indicated or implied that the devices or elements referred to must have a specific orientation, be constructed and operate in a specific orientation, and therefore should not be construed as limitations of the present disclosure. In addition, the terms "first", "second", etc. are only for description, can not be understood as indicating or implying relative importance or implicitly indicating the quantity of indicated technical features. Therefore, the features defined as "first" and "second" may include one or more of these features explicitly or implicitly. In the description of the present disclosure, unless otherwise specified, "plurality" means two or more.

In the description of the present disclosure, it should be noted that unless otherwise specified and limited, the terms "installation", "connection" and "configuration" should be broadly understood, for example, they can be fixed connection, detachable connection or integrated connection. It can be directly connected or indirectly connected through an intermediary. For those skilled in the art, the specific meanings of the above terms in the present disclosure can be understood in specific circumstances.

In the description of the present disclosure, the N electrode is the negative electrode and the P electrode is the positive electrode.

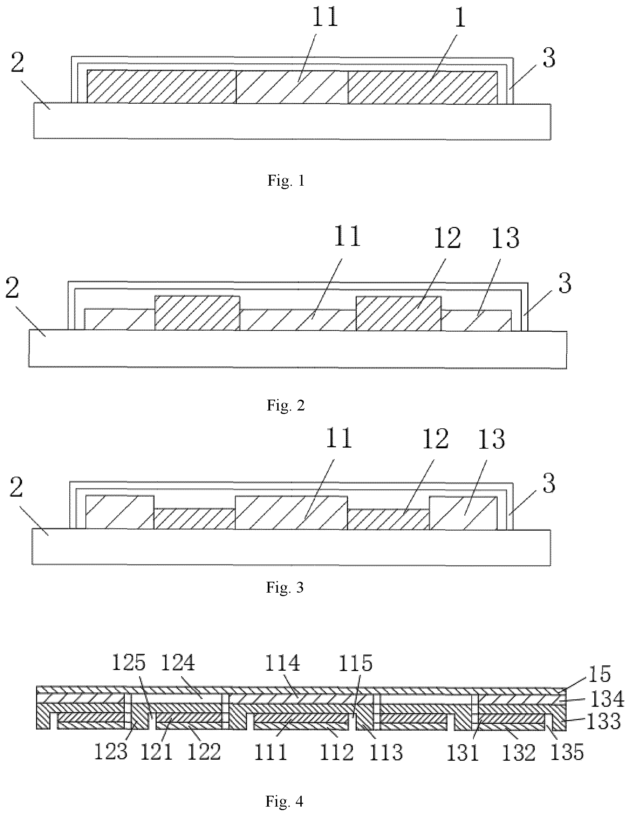

As shown in Fig. 1, a ring light source with adjustable color temperature is provided in a first embodiment of the present disclosure, including, a substrate 2 and a light source group 1; the light source group 1 is arranged on the substrate 2. The light source group 1 includes a basic light source 11 and a ring light source sleeved outside the basic light source 11. The basic light source 11 is arranged with a basic P electrode and a basic N electrode, and the basic P electrode and the basic N electrode are electrically connected. The ring light source is arranged with a ring P electrode and a ring N electrode, and the ring P electrode and the ring N electrode are electrically connected. A color temperature of the basic light source 11 is different from a color temperature of the ring light source. The basic light source 11 and the ring light source are both flip-chip LED structures.

The way of electrical connection can be to connect an external power supply, so that the current supplied by the power supply supplies power to the basic light source 11 and the ring light source, making the N electrode and the corresponding P electrode (such as the basic P electrode, the basic N electrode, the ring P electrode, and the ring N electrode) form a complete loop. The color temperature of the basic light source 11 is different from the color temperature of the ring light source. Specifically, the color temperature of the basic light source 11 is Y, while the color temperature of the ring light source is W, and Y is not equal to W. The arrangement of the basic light source 11 and the ring light source can mix a light emitted by the basic light source 11 and a light emitted by the ring light source when emitting light, so as to achieve the effect of uniform light emission.

Compared with the traditional wire bonding LED chip structures, the flip-chip LED structure can provide a better heat conduction path, accelerate a heat dissipation of the LED chip, and improve a life and stability of the LED. The flip-chip LED structure can reduce an optical impedance between the LED chip and environment, improve the light output efficiency, brightness and brightness uniformity (that is, spot uniformity). Both the basic light source 11 and the ring light source can be of a thin film flip-chip LED structure, which can further increase the light emitting efficiency.

The ring light source with adjustable color temperature in the embodiment includes a substrate 2 and a light source group 1 arranged on the substrate 2, where the light source group 1 includes a basic light source 11 and a ring light source sleeved outside the basic light source 11; and the basic light source 11 and the ring light source are electrically connected through their own N electrodes and P electrodes, so that electric cells of the basic light source 11 and the ring light source can be adjusted to be different or the current power in the N electrodes and P electrodes of the two can be adjusted to make their own color temperatures different, thereby realizing various color temperature transformations. At the same time, both the basic light source 11 and the ring light source are flip-chip LED structures, which can reduce light shielding. The sleeved arrangement between the basic light source 11 and the ring light source can reduce a gap, improve a compactness, improve an effective light output, and enhance a brightness and spot uniformity.

Both the basic light source 11 and the ring light source are flip-chip LED structures, and the basic light source 11 includes a basic luminescent layer 111 and a basic fluorescent layer 114. The basic P electrode and the basic N electrode are respectively connected to the basic luminescent layer 111 to supply power to the basic luminescent layer 111. The basic fluorescent layer 114 is arranged above the basic luminescent layer 111, and is configured to convert a light of a luminescent layer into an visible light, and adjust a distribution of the light to make the light more uniform and consistent, and to enhance the light efficiency. Similarly, the ring light source includes a ring luminescent layer and a ring fluorescent layer, and the ring P electrode and the ring N electrode are connected to the ring luminescent layer to supply power to the ring luminescent layer. The ring fluorescent layer is arranged above the ring luminescent layer. A thickness and material of the basic luminescent layer 111 can be adjusted to be different from a thickness and material of the ring light-emitting layer, so that the color temperature of the basic light source 11 is different from the color temperature of the ring light source. At the same time, a thickness and material of the basic fluorescent layer 114 can also be adjusted to be different from a thickness and material of the ring luminescent layer, so that the color temperature of the basic light source 11 is different from the color temperature of the ring light source.

In some embodiments, the ring light source includes a first ring light source 12 and a second ring light source 13, where the first ring light source 12 is sleeved outside the basic light source 11, and the second ring light source 13 is sleeved outside the first ring light source 12. The ring P electrode includes a first P electrode and a second P electrode, and the ring N electrode includes a first N electrode and a second N electrode. The first P electrode and the first N electrode are both connected to the first ring light source 12, and the first P electrode and the first N electrode are electrically connected. The second P electrode and the second N electrode are both connected to the second ring light source 13, and the second P electrode and the second N electrode are electrically connected. A color temperature of the basic light source 11 is different from a color temperature of the first ring light source 12, or the color temperature of the basic light source 11 is different from a color temperature of the second ring light source 13.

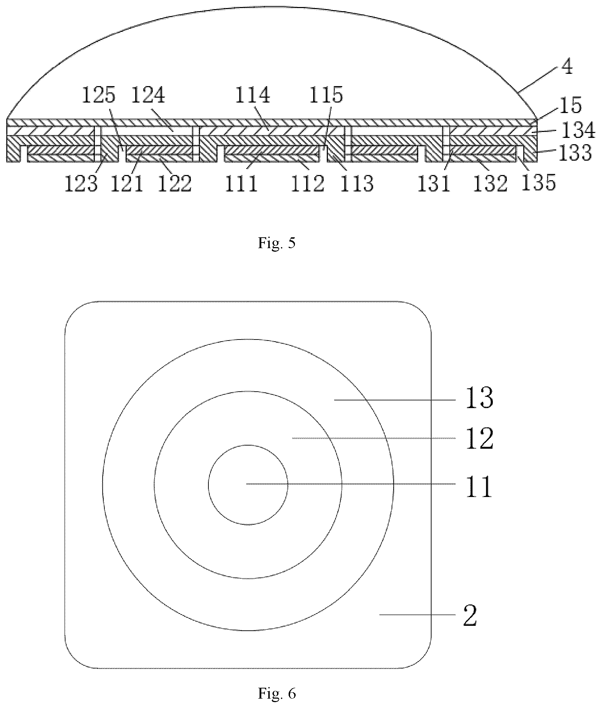

By adjusting the color temperature of the basic light source 11 to be different from the color temperature of the first ring light source 12 or the second ring light source 13, the color temperature of the light source can be continuously adjusted. Specifically, both the color temperatures of the basic light source 11 and the ring light source (including the first ring light source 12 and the second ring light source 13) can be designed with a color temperature of 2700 K to 6400 K. For example, the color temperature of the basic light source 11 is the same as the color temperature of the second ring light source 13, both of which are Y, but different from the color temperature of the first ring light source 12, the color temperature of the first ring light source 12 is W, and Y is not equal to W, both of the color temperatures are in the range of 2700 K to 6400 K, as shown in Figs. 2 and 6. Alternatively, the color temperature of the basic light source 11 is the same as the color temperature of the second ring light source 13, both being W, but different from the color temperature of the first ring light source 12, the color temperature of the first ring light source 12 is Y, as shown in Figs. 3 and 6.

The color temperature of the basic light source 11 can be different from the color temperatures of both the first ring light source 12 and the second ring light source 13. By increasing the color temperature from the inside to the outside (that is, the extending direction of the basic light source 11 to the ring light source) or decreasing the color temperature from the inside to the outside, an effect of light gradient mixing can be achieved, thus improving the uniformity of light spots. Specifically, the color temperature difference between adjacent light sources is less than or equal to 500 K, which can make the light achieve a better smooth transition and continuous effect.

Material or thicknesses of the fluorescent layer can affect the light conversion, and the color temperature of the light source can be adjusted by the material or the thickness of the fluorescent layer. In some embodiments, the basic light source 11 includes a basic fluorescent layer 114, the first ring light source 12 includes a first fluorescent layer 124, and the second ring light source 13 includes a second fluorescent layer 134. A thickness of the basic fluorescent layer 114 is different from a thickness of the first fluorescent layer 124, or the thickness of the basic fluorescent layer 114 is different from a thickness of the second fluorescent layer 134.

Fluorescent powder can be added to the fluorescent layer, and the distribution, color and thickness of the fluorescent powder can affect the light conversion. In order to ensure the uniformity of light and the uniformity of light spots, it is preferred that the fluorescent powder in the fluorescent layer are evenly distributed. Moreover, the color temperature of the light source can be adjusted by the color and thickness of the fluorescent powder. In some embodiments, the fluorescent powder is arranged in the basic fluorescent layer 114, the first fluorescent layer 124, and the second fluorescent layer 134, and the thickness of the fluorescent powder in the basic fluorescent layer 114 is different from the thickness in the first fluorescent layer 124, or the thickness of the fluorescent powder in the basic fluorescent layer 114 is different from the thickness in the second fluorescent layer 134. That is, the color temperatures of the basic light source 11, the first ring light source 12, and the second ring light source 13 can be adjusted by adjusting the colors and thicknesses of the fluorescent powders arranged in the basic fluorescent layer 114, the first fluorescent layer 124, and the second fluorescent layer 134, respectively.

In some embodiments, the basic light source 11 further includes a basic luminescent layer 111, where both the basic P electrode and the basic N electrode are arranged on the basic luminescent layer 111, and the basic fluorescent layer 114 is arranged above the basic luminescent layer 111. The first ring light source 12 further includes a first luminescent layer 121, where the first P electrode and the first N electrode are both arranged on the first luminescent layer 121, and the first fluorescent layer 124 is arranged above the first luminescent layer 121. The second ring light source 13 further includes a second luminescent layer 131, where the second P electrode and the second N electrode are both arranged on the second luminescent layer 131, and the second fluorescent layer 134 is arranged above the second luminescent layer 131. The fluorescent layer is arranged above the luminescent layer, which can convert the light of the luminescent layer into visible light, and adjust the distribution of light at the same time, so that the light is more uniform and consistent, and the light effect can be enhanced.

The color temperature of the luminescent layer can be adjusted by adjusting the current flow and power, or by adjusting the material and thickness of the luminescent layer. In some embodiments, the color temperature of the basic luminescent layer 111 is different from the color temperature of the first luminescent layer 121, and the color temperature of the first luminescent layer 121 is the same as the color temperature of the second luminescent layer 131. Alternatively, the color temperature of the basic luminescent layer 111 is different from the color temperature of the first luminescent layer 121, and the color temperature of the basic light source 11 is the same as the color temperature of the second luminescent layer 131. In some embodiments, the thickness of the basic luminescent layer 111 is different from the thickness of the first luminescent layer 121, or the thickness of the basic luminescent layer 111 is different from the thickness of the second luminescent layer 131.

The P electrode and the N electrode can be protected by the arrangement of the epitaxial layer, so as to prevent the electrode from being damaged and the light source from failing or being damaged. As shown in Fig. 4, in some embodiments, the basic light source 11 further includes a basic P epitaxial layer 112 and a basic N epitaxial layer 113, where the basic P electrode is arranged in the basic P epitaxial layer 112 and the basic N electrode is arranged in the basic N epitaxial layer 113, and the basic P epitaxial layer 112 covers the lower surface of the basic luminescent layer 111 and the basic N epitaxial layer 113 covers the upper surface of the basic luminescent layer 111. The first ring light source 12 further includes a first P epitaxial layer 122 and a first N epitaxial layer 123, where the first P electrode is arranged in the first P epitaxial layer 122, the first N electrode is arranged in the first N epitaxial layer 123, the first P epitaxial layer 122 covers the lower surface of the first luminescent layer 121, and the first N epitaxial layer 123 covers the upper surface of the first luminescent layer 121. The second ring light source 13 further includes a second P epitaxial layer 132 and a second N epitaxial layer 133, where the second P electrode is arranged in the second P epitaxial layer 132, the second N electrode is arranged in the second N epitaxial layer 133, the second P epitaxial layer 132 covers a lower surface of the second luminescent layer 131, and the second N epitaxial layer 133 covers an upper surface of the second luminescent layer 131.

In order to facilitate the electrical connection between the N electrode and the P electrode, a gap is arranged between the luminescent layer and the N epitaxial layer to facilitate the passage of the N electrode or the P electrode. In some embodiments, a basic gap 115 is arranged between the basic luminescent layer 111 and the basic N epitaxial layer 113, and the basic P electrode is electrically connected to the basic N electrode through the basic gap 115. A first gap 125 is arranged between the first luminescent layer 121 and the first N epitaxial layer 123, and the first P electrode is electrically connected to the first N electrode through the first gap 125. A second gap 135 is arranged between the second luminescent layer 131 and the second N epitaxial layer 133, and the second P electrode is electrically connected to the second N electrode through the second gap 135.

A plurality of ring light sources are arranged, and the color temperatures of the plurality of ring light sources may be different from the color temperature of the basic light source 11 and may be adjusted by users, so as to meet the needs of different users.

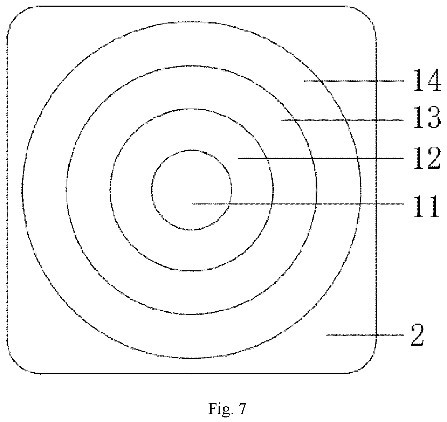

As shown in Fig. 7, in some embodiments, the ring light source further includes a third ring light source 14, the third ring light source 14 is sleeved outside the second ring light source 13, and a color temperature of the third ring light source 14 is different from the color temperature of the basic light source 11, or the color temperature of the third ring light source 14 is different from the color temperature of the second ring light source 13. A structure of the third ring light source 14 can be the same as structures of the first ring light source 12 and the second ring light source 13. That is to say, the structure can all contain N electrode, P electrode, luminescent layer, and fluorescent layer, and the N electrode can all be arranged in the N epitaxial layer, and the P electrode can be arranged in the P epitaxial layer. The color temperature of the ring light source can be adjusted by adjusting the current flowing through the N electrode and the P electrode, and adjusting the materials and thickness of the luminescent layer and the fluorescent layer.

In some embodiments, the ring light source further includes a third ring light source 14 up to the Xth ring light source. The first ring light source 12, the second ring light source 13, and the third ring light source 14, up to the Xth ring light source, form a total of X ring light sources. The third ring light source 14 is sleeved outside the second ring light source 13, and so on, with the Xth ring light source is sleeved outside the (X-1)th ring light source. A color temperature of the Xth ring light source is different from the color temperature of the basic light source 11, or the color temperature of the Xth ring light source is different from a color temperature of the (X-1)th ring light source. A structure of the ring light source can be the same as structures of the first ring light source 12 and the second ring light source 13. That is to say, the X ring light sources can all contain N electrode, P electrode, luminescent layer, and fluorescent layer, and the N electrodes can all be arranged in the N epitaxial layers and the P electrodes can all be arranged in the P epitaxial layers. The color temperature of the ring light source can be adjusted by adjusting the current flowing through the N electrode and the P electrode, and adjusting the materials and thickness of the luminescent layer and the fluorescent layer.

In some embodiments, the technical schemes of the present disclosure can adjust the thicknesses of the luminescent layer and the fluorescent layer of the basic light source 11 and the ring light source in the light source group 1 according to the actual application scenario, so as to ensure good luminous efficiency. In another aspect, under a condition that the thicknesses of the luminescent layer and the fluorescent layer of the basic light source 11 and the ring light source in the light source group 1 are unchanged, the corresponding color temperature can also be adjusted by adjusting the current flowing through the N electrode and the P electrode, adjusting the materials of the luminescent layer and the fluorescent layer, and adjusting the color of the fluorescent powder.

As shown in Fig. 5, in some embodiments, the ring light source with adjustable color temperature further includes a lens 4, and the lens 4 is arranged above the light source group 1. The lens 4 can be arranged according to actual needs, for instance, a convex lens 4 when is applied to places where light is concentrated, such as flashlights, projectors, sunglasses, etc. For applications where uniform illumination is needed to reduce the light intensity, such as headlights and street lamps of automobiles, the lens 4 can be a concave lens 4.

The light source group 1 may further include a protective layer 15, which is arranged above the fluorescent layer (including the basic fluorescent layer 114 of the basic light source 11 and the ring fluorescent layer of the ring light source) and completely covers the fluorescent layer to prevent the fluorescent layer from being damaged.

The ring light source with adjustable color temperature may further include a protective shell 3, which is arranged above the light source group 1, forms an internal cavity space together with the substrate 2, and completely covers the light source group 1 in the cavity space for protecting the light source group 1. Specifically, the lens 4 can be arranged in the protective shell 3, and between the protective shell 3 and the light source group 1. The lens 4 can also be arranged outside and above the protective shell 3, so that the lens 4 can be replaced conveniently.

In summary, the present disclosure provides a ring light source with adjustable color temperature, including a substrate and a light source group arranged on the substrate, where the light source group includes a basic light source and a ring light source sleeved outside the basic light source, and the basic light source and the ring light source are electrically connected through their own N electrodes and P electrodes, so that the battery cells of the basic light source and the ring light source can be adjusted to be different or the current power in the N electrodes and P electrodes of the two can be adjusted to make the color temperatures of the two different, thereby realizing various color temperature transformations. At the same time, both the basic light source and the ring light source are flip-chip LED structures, which can reduce the light shielding. The sleeved arrangement of the basic light source and the ring light source can reduce the interval between them, improve the effective output of light, and enhance the brightness and the uniformity of light spots.

Finally, it should be noted that the above embodiments are only used to illustrate the technical schemes of the present disclosure, but not to limit the present disclosure. Although the present disclosure has been described in detail with reference to the aforementioned embodiments, it should be understood by those skilled in the art that they can still modify the technical schemes recorded in the embodiments or replace some technical features with equivalents. However, these modifications or substitutions do not make the essence of the corresponding technical schemes deviate from the spirit and scope of the technical solutions exemplified in the present disclosure.

## Claims

1. A ring light source with adjustable color temperature, comprising:
a substrate;
a light source group arranged on the substrate;
wherein the light source group comprises a basic light source and a ring light source sleeved outside the basic light source; the basic light source is arranged with a basic P electrode and a basic N electrode, and the basic P electrode and the basic N electrode are electrically connected; the ring light source is arranged with a ring P electrode and
a ring N electrode, and the ring P electrode and the ring N electrode are electrically connected;
a color temperature of the basic light source is different from a color temperature of the ring light source; the basic light source and the ring light source are both flip-chip LED structures.

2. The ring light source with adjustable color temperature according to claim 1, wherein the ring light source comprises a first ring light source and a second ring light source, the first ring light source is sleeved outside the basic light source, and the second ring light source is sleeved outside the first ring light source;
the ring P electrode comprises a first P electrode and a second P electrode, and the ring N electrode comprises a first N electrode and a second N electrode; the first P electrode and the first N electrode are both connected to the first ring light source, and the first P electrode and the first N electrode are electrically connected; the second P electrode and the second N electrode are both connected to the second ring light source, and the second P electrode and the second N electrode are electrically connected;
the color temperature of the basic light source is different from a color temperature of the first ring light source, or the color temperature of the basic light source is different from a color temperature of the second ring light source.

3. The ring light source with adjustable color temperature according to claim 2, wherein the basic light source comprises a basic fluorescent layer, the first ring light source comprises a first fluorescent layer, and the second ring light source comprises a second fluorescent layer; a thickness of the basic fluorescent layer is different from a thickness of the first fluorescent layer, or the thickness of the basic fluorescent layer is different from a thickness of the second fluorescent layer.

4. The ring light source with adjustable color temperature according to claim 3, wherein fluorescent powder is arranged in the basic fluorescent layer, the first fluorescent layer, and the second fluorescent layer, and a thickness of the fluorescent powder in the basic fluorescent layer is different from a thickness in the first fluorescent layer, or the thickness of the fluorescent powder in the basic fluorescent layer is different from a thickness in the second fluorescent layer.

5. The ring light source with adjustable color temperature according to claim 3, wherein the basic light source further comprises a basic luminescent layer, the basic P electrode and the basic N electrode are both arranged on the basic luminescent layer, and the basic fluorescent layer is arranged above the basic luminescent layer;
the first ring light source further comprises a first luminescent layer, wherein the first P electrode and the first N electrode are both arranged on the first luminescent layer, and the first fluorescent layer is arranged above the first luminescent layer;
the second ring light source further comprises a second luminescent layer, wherein the second P electrode and the second N electrode are both arranged on the second luminescent layer, and the second fluorescent layer is arranged above the second luminescent layer.

6. The ring light source with adjustable color temperature according to claim 5, wherein a thickness of the basic luminescent layer is different from a thickness of the first luminescent layer, or the thickness of the basic luminescent layer is different from a thickness of the second luminescent layer.

7. The ring light source with adjustable color temperature according to claim 5, wherein the basic light source further comprises a basic P epitaxial layer and a basic N epitaxial layer, wherein the basic P electrode is arranged in the basic P epitaxial layer, the basic N electrode is arranged in the basic N epitaxial layer; the basic P epitaxial layer covers a lower surface of the basic luminescent layer, the basic N epitaxial layer covers an upper surface of the basic luminescent layer, and the basic fluorescent layer is arranged above the basic N epitaxial layer;
the first ring light source further comprises a first P epitaxial layer and a first N epitaxial layer, wherein the first P electrode is arranged in the first P epitaxial layer, the first N electrode is arranged in the first N epitaxial layer, the first P epitaxial layer covers a lower surface of the first luminescent layer, the first N epitaxial layer covers an upper surface of the first luminescent layer, and the first fluorescent layer is arranged above the first N epitaxial layer;
the second ring light source further comprises a second P epitaxial layer and a second N epitaxial layer, wherein the second P electrode is arranged in the second P epitaxial layer, the second N electrode is arranged in the second N epitaxial layer; the second P epitaxial layer covers a lower surface of the second luminescent layer, the second N epitaxial layer covers an upper surface of the second luminescent layer, and the second fluorescent layer is arranged above the second N epitaxial layer.

8. The ring light source with adjustable color temperature according to claim 7, wherein a basic gap is arranged between the basic luminescent layer and the basic N epitaxial layer, and the basic P electrode is electrically connected to the basic N electrode through the basic gap;
a first gap is arranged between the first luminescent layer and the first N epitaxial layer, and the first P electrode is electrically connected to the first N electrode through the first gap;
a second gap is arranged between the second luminescent layer and the second N epitaxial layer, and the second P electrode is electrically connected to the second N electrode through the second gap.

9. The ring light source with adjustable color temperature according to claim 2, wherein the ring light source further comprises a third ring light source to an Xth ring light source; the first ring light source, the second ring light source and the third ring light source, up to the Xth ring light source, form a total of X ring light sources; the third ring light source is sleeved outside the second ring light source, and so on, with the Xth ring light source is sleeved outside an (X-1)th ring light source; a color temperature of the Xth ring light source is different from the color temperature of the basic light source, or the color temperature of the Xth ring light source is different from a color temperature of the (X-1)th ring light source.

10. The ring light source with adjustable color temperature according to claim 1, further comprising a lens, and the lens is arranged above the light source group.
